# FASCICULE DE BREVET EUROPEEN

(11) **EP 0 997 936 B1**
(45) Date de publication et mention de la délivrance du brevet: **31.03.2004**
(21) Numéro de dépôt: 99402651.6
(22) Date de dépôt: 25.10.1999
(51) Int. Cl.: H01L 23/13, H01L 23/482

(54) **Procédé de fabrication d'une électrode de commande de grille pour transistor IGBT.**
Verfahren zur Herstellung von IGBT-Gateelektroden
Manufacturing method for an IGBT gate electrode

(30) Priorité: 30.10.1998 FR 9813691
(43) Date de publication de la demande: 03.05.2000
(73) Titulaire: Alstom Holdings, 75116 Paris (FR)
(72) Inventeur: Changey, Nicolas, 52140 Montigny-le-Roi (FR); Petitbon, Alain, 78730 St.-Arnoult-en-Yvelines (FR); Crouzy, Sophie, 91440 Bures-sur-Yvette (FR); Ranchy, Eric, 94800 Villejuif (FR)
(74) Mandataire: Moncheny, Michel

(56) Documents cités:
- WO-A-98/02925
- FR-A- 2 335 953
- US-A- 5 319 237
- PATENT ABSTRACTS OF JAPAN vol. 098, no. 001, 30 janvier 1998 (1998-01-30) & JP 09 232332 A (FUJI ELECTRIC CO LTD), 5 septembre 1997 (1997-09-05)

## Description

La présente invention est relative à un procédé de fabrication d'une électrode de commande de grille pour transistor bipolaire à grille isolée (IGBT).

Ce type de transistor est généralement monté sur une plaquette de circuits intégrés pourvue d'électrodes, d'émetteur, de collecteur et de commande de grille soudées sur des emplacements de connexion correspondants de la plaquette.

En fonctionnement, l'électrode de commande de grille pilote sélectivement la transition à l'état fermé ou ouvert des IGBT. Elle doit nécessairement être isolée des électrodes d'émetteur et de collecteur.

Le but de l'invention est de fournir un procédé de fabrication d'une électrode de commande de grille pour IGBT, permettant, à partir d'une plaque de matériau électriquement conducteur recouverte d'une couche électriquement isolante et délimitant, sur une de ses grandes faces, un plot de connexion destiné à être soudé sur la grille, de réaliser une électrode de commande de grille isolée du reste de la plaque.

Elle a donc pour objet un procédé de fabrication d'une électrode de commande de grille pour transistor bipolaire à grille isolée, caractérisé en ce qu'il comporte les étapes consistant à :
- former sur le plot de connexion sur une couche électriquement conductrice recouvrant la couche électriquement isolante ;
- former sur la plaque une piste électriquement conductrice d'alimentation du plot de connexion ; et
- enterrer la piste d'alimentation sous une deuxième souche électriquement isolante.

Le procédé de fabrication selon l'invention peut en outre comporter une ou plusieurs des caractéristiques suivantes, prise isolément ou selon toutes les combinaisons techniquement possibles.
- la plaque est réalisée en un matériau métallique anodisé, notamment de l'aluminium, la couche électriquement conductrice et la piste d'alimentation étant formées par métallisation locale de la couche anodisée,
- la métallisation locale de la couche anodisée est effectuée par traitement laser,
- postérieurement au traitement laser de la couche anodisée, on dépose sur la piste formée une couche de métal,
- il comporte en outre une étape consistant à enterrer la piste d'alimentation sous une deuxième couche électriquement isolante.
- l'étape consistant à enterrer la piste d'alimentation consiste à anodiser cette dernière,
- on dépose en outre sur le plot une couche de matériau anti-oxydant,
- le matériau anti-oxydant est choisi parmi le nickel, le chrome, l'or ou un alliage de ces matériaux.

D'autres caractéristiques et avantages ressortiront de la description suivante, donnée uniquement à titre d'exemple, et faite en référence aux dessins annexés sur lesquels :
- la figure 1 est une vue schématiquement en perspective d'une plaquette de circuits intégrés dotée de transistors IGBT et d'une plaque délimitant des électrodes d'émetteur et de commande de grille ;
- la figure 2 est une vue en coupe selon le plan 2-2 de la plaque de la figure 1;
- les figures 3,4,5 et 6 sont des vues en coupe selon le plan 3-3 de la plaque de la figure 1, montrant les différentes étapes de réalisation de l'électrode de commande de grille et des électrodes d'émetteur ; et
- la figure 7 est une vue schématique en perspective d'un autre mode de réalisation d'une plaque de la figure 1.

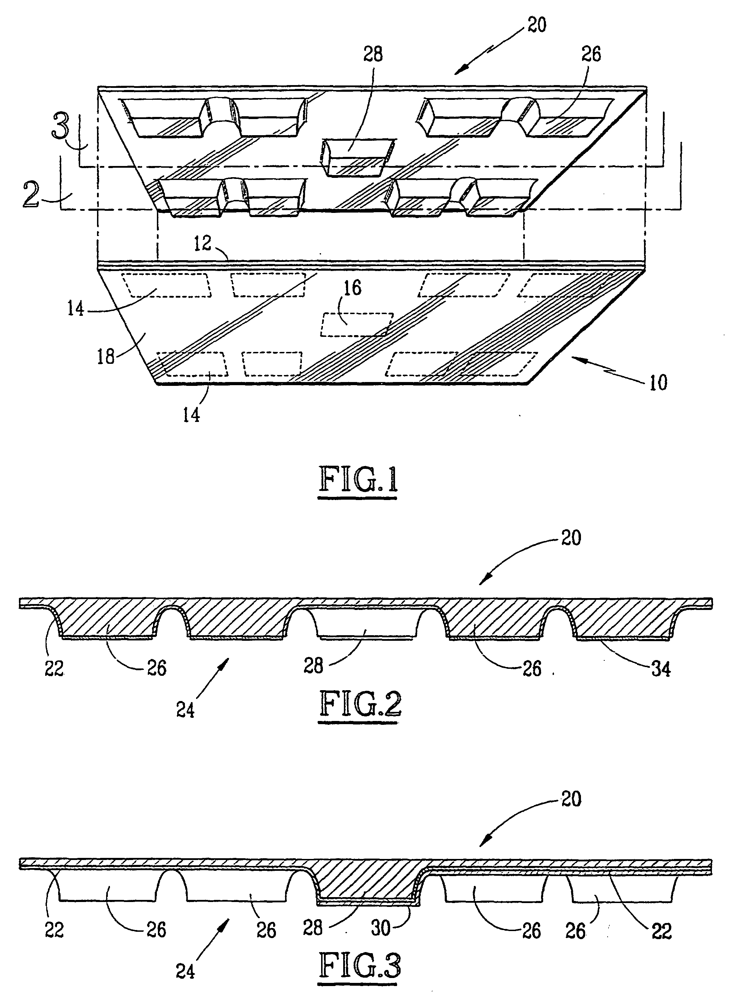

Sur la figure 1, on a représenté une plaquette de circuits intégrés, désignée par la référence numérique générale 10.

Elle est constituée par une plaquette de type classique, réalisée à partir d'une plaquette de silicium dans laquelle sont réalisées, par des techniques conventionnelles, des puces de transistor bipolaire à grille isolée, non représentées sur cette figure.

La plaquette 10 comporte une couche 12 de passivation, réalisée par exemple en polyamide, recouvrant la majeure partie de l'une des grandes faces de la plaquette 10 de manière à isoler le silicium sous-jacent.

Des zones d'interruption de la couche de passivation 12 délimitent un ensemble d'emplacements de connexions, tel que 14 pour le raccordement d'électrodes d'émetteur et un emplacement de connexion 16 pour le raccordement d'une électrode de commande de grille.

Comme cela est classique, les emplacements de connexion 14 et 16 sont recouverts d'une couche d'aluminium afin de protéger le silicium sous-jacent.

La grande face opposée de la plaquette 10 est pourvue d'une plaque métallique 18 constituant une électrode de collecteur.

En se référant également aux figures 2 et 3, les électrodes d'émetteurs et de commande de grille sont réalisées en une seule pièce 20 sous la forme d'une plaque en matériau électriquement conducteur, par exemple de l'aluminium.

Bien que cette plaque 20 puisse être réalisée à partir de tout autre type de matériau approprié pour l'utilisation envisagée, on considérera, dans la suite de la description, qu'elle est réalisée en aluminium anodisé de manière à la rendre insensible à l'oxydation, c'est-à-dire comportant une couche externe 22 d'alumine (figures 2 et 3).

La grande face 24 de la plaque 20, tournée vers la plaquette de circuit intégré 10, comporte un ensemble de plots de connexion, tels que 26 et 28, constituant les uns, 26, des électrodes d'émetteur, et l'autre, 28, une électrode de commande de grille, ces plots venant se souder sur les emplacements de connexion 14 et 16 ménagés dans la plaquette 10.

La description détaillée du procédé de réalisation de la plaque 20 va maintenant être faite en référence aux figures 3 à 6, sur lesquelles certains détails ont été exagérés par soucis de clarté.

En se référant tout d'abord à la figure 3, la première phase de réalisation consiste à former une plaque 20 en aluminium anodisé comportant, sur l'une de ses grandes faces 24, les plots 26 formant électrodes d'émetteur ainsi que le plot 28 formant électrode de commande de grille.

Comme mentionné précédemment, la plaque 20 est recouverte extérieurement d'une couche anodisée 22 de passivation en alumine de manière à la rendre inerte.

Cette couche 22 est ensuite métallisée localement de manière à constituer une piste 30 d'alimentation du plot 28 formant électrode de commande de grille, cette piste 30 recouvrant également ce plot 28.

Cette piste 30 est réalisée, par exemple, au moyen d'un laser excimère ou à ultraviolets capable de décomposer en surface l'alumine constitutive de la couche 22 pour reformer de l'aluminium, de manière à la rendre conductrice.

Lors de l'étape suivante, la piste 30 est anodisée de manière à l'enterrer pour l'isoler électriquement de l'extérieur.

On obtient alors la plaquette 20 visible sur la figue 4 dans laquelle la piste 30 est recouverte d'une couche d'alumine 32.

En variante, dans le cas où la couche de passivation 22 n'est pas suffisamment épaisse pour subir, après formation de la piste 30, une anodisation tout en conservant une épaisseur suffisante d'aluminium dans la piste 30, préalablement à cette anodisation, on dépose une couche d'aluminium après l'étape de métallisation de la couche anodisée 22.

La plaque 20 subit ensuite une phase d'usinage des plots 26 et 28 de manière à mettre à nu l'aluminium sous-jacent. On obtient ainsi la plaque 20 représentée sur la figure 5, dans laquelle la couche de métal constitutive de la piste d'alimentation et recouvrant le plot 28 de commande de grille s'étend entre deux couches électriquement isolantes obtenues par anodisation..

L'étape finale consiste à recouvrir les plots 26 et 28 d'une couche 34 de matériau anti-oxydant capable en outre de permettre une soudure des plots sur les emplacements de connexion 14 et 16 (figure 1).

Par exemple, la couche de matériau anti-oxydant est constituée de nickel, de chrome, d'or, ou d'un alliage de ces métaux.

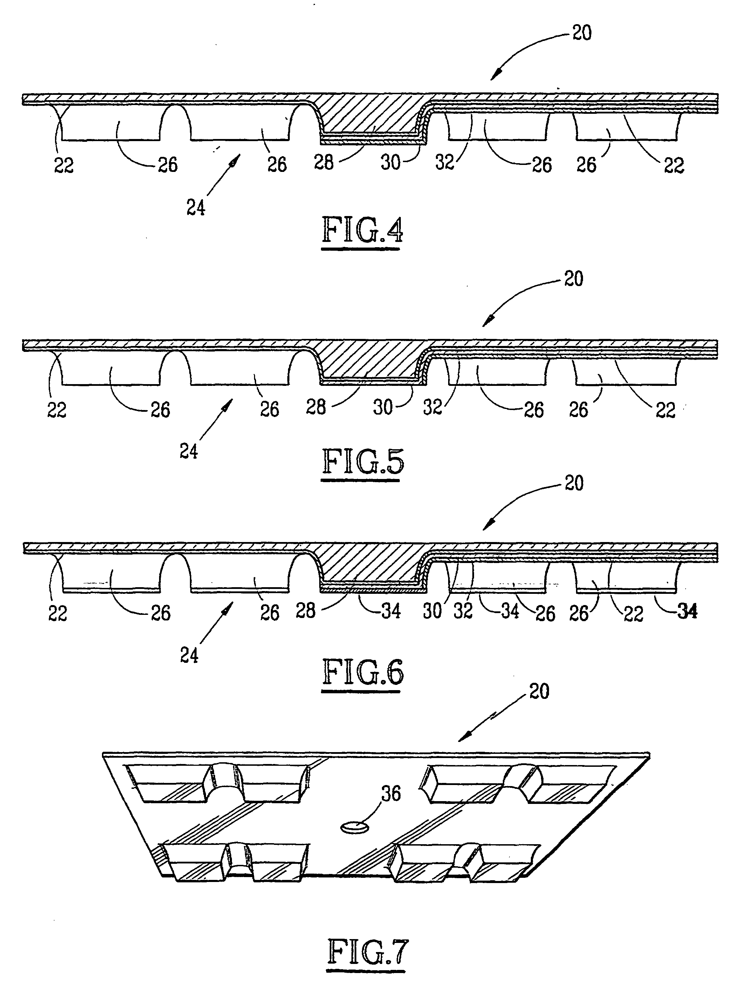

La plaque 20 ainsi obtenue, visible sur la figure 6, comporte un ensemble de plots 26 venus de matière, venant se souder sur les emplacements de connexion 14 correspondants en vue de l'alimentation de l'émetteur des puces d'IGBT, ainsi qu'un plot 28 constituant une électrode de commande de grille venant se souder sur l'emplacement de connexion 16 correspondant.

Ce plot 28 de commande de grille est isolé du reste de la plaque 20 par les couches 22 et 32 anodisées et est associé à une piste d'alimentation 30 elle-même isolée du reste de la plaque 20 par la deuxième couche 32 anodisée.

Pour procéder au soudage de la plaque 20 sur la plaquette 10 de circuits intégrés, il convient tout d'abord de désoxyder les emplacements de connexion 14 et 16, en trempant, par exemple, la plaquette 10 dans un bain d'acide nitrique, de préférence pendant 30 secondes.

On dépose sur les emplacements de connexion 14 et 16 désoxydés une couche de matériau anti-oxydant, par exemple le même matériau que celui utilisé pour rendre inoxydables les plots de connexion 26 et 28 de la plaque 20, c'est-à-dire du nickel, du chrome, de l'or ou un alliage de ces métaux.

On dépose ensuite des préformes de brasure sur les emplacements de connexion 14 et 16, par exemple en SnPbAg.

Après avoir positionné la plaque 20 sur la plaquette 10 de manière que les plots de connexion 26 et 28 de la plaque 20 soient appliqués contre les emplacements de connexion 14 et 16 correspondants de la plaquette de circuits intégrés 10, on place le tout dans un four en vue du soudage de l'ensemble.

On notera que, de préférence, la plaque métallique 18 constituant l'électrode de collecteur est soudée simultanément au soudage de la plaque 20 sur la plaquette de circuits intégrés 10.

On conçoit que l'invention qui vient d'être décrite, permet l'alimentation des émetteurs des puces d'IGBT, avec un courant relativement important, jusqu'à quelques centaines d'ampères, dans la mesure où les électrodes d'émetteur sont réalisées en une seule pièce, et ce tout en conservant la possibilité de prévoir une électrode de commande de grille intégrée à la plaque, tout en étant isolée du reste de celle-ci.

Il est toutefois possible, en variante, et comme représenté sur la figure 7, de prévoir un accès pour le soudage d'une électrode de commande de grille distincte des électrodes d'émetteur, en ménageant un orifice 36 dans la plaque 20 de manière à permettre le passage d'une électrode (non représentée), avec interposition d'un matériau électriquement isolant.

Dans la description de la plaque faite précédemment, on conçoit que la grande face de la plaque 20 opposée aux plots de raccordement 26 et 28 peut être dotée de moyens de refroidissement appropriés permettant ainsi une augmentation considérable du nombre de puces intégrées à la plaquette 10, dans la mesure où il est possible de faire circuler dans la plaque 20 un courant d'alimentation relativement important.

Par exemple, les moyens de refroidissement peuvent être configurés sous la forme de canaux dans lesquels circule un fluide de refroidissement, par exemple de l'eau desionisée.

On notera enfin que la plaque formant électrodes d'émetteur et de commande de grille peut être soudée sur des plaquettes de circuits intégrés disponibles dans le commerce.

Il est possible de réaliser les couches isolantes s'étendant de part et d'autre de la piste d'alimentation au moyen d'une technique différente, notamment par dépôt d'un revêtement électriquement isolant approprié.

## Revendications

1. Procédé de fabrication d'une électrode (28) de commande de grille pour transistor bipolaire à grille isolée, à partir d'une plaque (20) de matériau électriquement conducteur recouverte d'une couche (22) électriquement isolante et délimitant, sur une de ses grandes faces, un plot de connexion destiné à être soudé sur la grille, comportant les étapes consistant à :
- former sur le plot de connexion une couche (30) électriquement conductrice recouvrant la couche (22) électriquement isolante ;
- former sur la plaque une piste (30) électriquement conductrice d'alimentation du plot de connexion ; et
- enterrer la piste d'alimentation (30) sous une deuxième couche (32) électriquement isolante.

2. Procédé selon la revendication 1, **caractérisé en ce que** la plaque (20) est réalisée en un matériau métallique anodisé, notamment de l'aluminium, la couche (30) électriquement conductrice et la piste (30) d'alimentation étant formées par métallisation locale de la couche (22) anodisée.

3. Procédé selon la revendication 2, **caractérisé en ce que** la métallisation locale de la couche anodisée (22) est effectuée par traitement laser.

4. Procédé selon la revendication 3, **caractérisé en ce que** postérieurement au traitement laser de la couche anodisée (22), on dépose sur la piste formée une couche de métal.

5. Procédé selon l'une quelconque des revendications 1 à 4, **caractérisé en ce que** l'étape consistant à enterrer la piste (30) d'alimentation consiste à anodiser cette dernière.

6. Procédé selon l'une quelconque des revendications 1 à 5, **caractérisé en ce qu'**il comporte en outre une étape consistant à déposer sur le plot une couche (34) de matériau anti-oxydant.

7. Procédé selon la revendication 6, **caractérisé en ce que** le matériau anti-oxydant est choisi parmi le nickel, le chrome, l'or ou un alliage de ces matériaux.

## Claims

1. Process for producing a gate electrode (28) for an insulated gate bipolar transistor, from a board (20) of electrically conductive material covered with an electrically insulating layer (22) and defining, on one of its large sides, a connecting contact intended to be welded to the gate, comprising the steps consisting of:
- forming on the connecting contact an electrically conductive layer (30) covering the electrically insulating layer (22);
- forming on the board an electrically conductive supply trace for the connecting contact; and
- burying the supply trace (30) under a second electrically insulating layer (32).

2. Process according to claim 1, **characterised in that** the board (20) is made of an anodised metallic material, notably aluminium, the electrically conductive layer (30) and the supply trace (30) being formed by local metallisation of the anodised layer (22).

3. Process according to claim 2, **characterised in that** the local metallisation of the anodised layer (22) is carried out by laser treatment.

4. Process according to claim 3, **characterised in that** subsequent to the laser treatment of the anodised layer (22), a layer of metal is deposited on the trace formed.

5. Process according to any one of claims 1 to 4, **characterised in that** the step comprising burying the supply trace (30) comprises anodising said trace (30).

6. Process according to any one of claims 1 to 5, **characterised in that** it further comprises a step consisting of depositing a layer (34) of antioxidant material on the contact.

7. Process according to claim 6, **characterised in that** the antioxidant material is selected from among nickel, chromium, gold or an alloy of these materials.

## Patentansprüche

1. Verfahren zum Herstellen einer Gate-Steuerelektrode (28) für einen Isolierschicht-Bipolartransistor ausgehend von einer Platte (20) aus einem elektrisch leitendem Material, die mit einer elektrisch isolierenden Lage (22) bedeckt ist und auf einer ihrer großen Flächen einen Anschlussfleck begrenzt, der auf das Gate gelötet werden soll, wobei das Verfahren die Schritte umfasst, die darin bestehen:
- auf dem Anschlussfleck eine elektrisch leitende Lage (30) zu bilden, die die elektrisch isolierende Lage (22) bedeckt;
- auf der Platte eine elektrisch leitende Versorgungsbahn (30) für den Anschlussfleck zu bilden; und
- die Versorgungsbahn unter einer zweiten elektrisch isolierenden Lage (32) zu vergraben.

2. Verfahren nach Anspruch 1, **dadurch gekennzeichnet, dass** die Platte (20) aus einem eloxierten Metallmaterial, insbesondere Aluminium, verwirklicht ist, wobei die elektrisch leitende Lage (30) und die Versorgungsbahn (30) durch lokale Metallisierung der eloxierten Lage (22) gebildet sind.

3. Verfahren nach Anspruch 2, **dadurch gekennzeichnet, dass** die lokale Metallisierung der eloxierten Lage (22) durch Laserbehandlung ausgeführt wird.

4. Verfahren nach Anspruch 3, **dadurch gekennzeichnet, dass** nach der Laserbehandlung der eloxierten Lage (22) auf der gebildeten Bahn eine Metalllage abgelagert wird.

5. Verfahren nach einem der Ansprüche 1 bis 4, **dadurch gekennzeichnet, dass** der Schritt, der darin besteht, die Versorgungsbahn (30) zu vergraben, darin besteht, diese zu eloxieren.

6. Verfahren nach einem der Ansprüche 1 bis 5, **dadurch gekennzeichnet, dass** es außerdem einen Schritt umfasst, der darin besteht, auf dem Fleck eine Lage (34) aus Antioxidationsmaterial abzulagern.

7. Verfahren nach Anspruch 6, **dadurch gekennzeichnet, dass** das antioxidierende Material aus Nickel, Chrom, Gold oder aus einer Legierung aus diesen Materialien ausgewählt ist.
